# EUROPÄISCHE PATENTSCHRIFT

(11) **EP 0 613 331 B1**
(45) Veröffentlichungstag und Bekanntmachung des Hinweises auf die Patenterteilung: **13.11.1996**
(21) Anmeldenummer: 94101655.2
(22) Anmeldetag: 03.02.1994
(51) Int. Cl.: H05K 3/34, H05K 3/36

(54) **Verfahren zum Befestigen einer Hybrid-Schaltung auf einer Leiterplatte**
Method of attaching a hybrid circuit on a pcb
Méthode d'attachement d'un circuit hybride sur un circuit imprimé

(30) Priorität: 26.02.1993 DE 4306021; 16.06.1993 DE 4319876
(43) Veröffentlichungstag der Anmeldung: 31.08.1994
(73) Patentinhaber: SIEMENS AKTIENGESELLSCHAFT, 80333 München (DE)
(72) Erfinder: Hans-Bodo, Laue, Ing., D-33184 Altenbeken (DE)

(56) Entgegenhaltungen:
- DE-A- 3 316 017
- PATENT ABSTRACTS OF JAPAN vol. 14, no. 190 (E-0918)18. April 1990 & JP-A-02 037 761 (NEC CORP) 7. Februar 1990
- PATENT ABSTRACTS OF JAPAN vol. 13, no. 568 (E-861)15. Dezember 1989 & JP-A-01 236 686 (MATSUSHITA ELECTRIC IN CO) 21. September 1989

## Beschreibung

Die Erfindung betrifft ein Verfahren gemäß dem Oberbegriff des Patentanspruchs 1. Ein solches Verfahren ist aus JP-A-02 037 761 und JP-A-01 236 686 bekannt.

Der technologische Trend, immer mehr Bauelemente in einem einzigen elektrischen Bauelement zu integrieren, ist momentan ungebrochen. Zu diesen Bauelementen gehören beispielsweise integrierte Schaltungen, aber auch Hybrid-Schaltungen sind in jene elektrischen Bauelemente einzugruppieren. Generell besteht eine Hybrid-Schaltung aus einem Trägersubstrat, auf dessen Oberfläche eine Reihe von Bauelementen wie z.B. Widerstände, Kondensatoren und integrierte Schaltungen angebracht sind. Zur elektrischen Kontaktierung wird das Trägersubstrat der Hybrid-Schaltung beispielsweise auf einer Leiterplatte befestigt. Dazu werden Lötflächen am Trägersubstrat ausgebildet. Diese haben elektrischen Kontakt zu den weiteren Anschlüssen der elektrischen Bauelemente der Hybrid-Schaltung. Im weiteren werden Kontaktstifte (Kämme) an den Lötflächen des Trägersubstrats angelötet und im folgenden in einem Schwallbad mit der Leiterplatte verbunden. Auf der Leiterplatte sind weitere oberflächenmontierbare Bauelemente angeordnet, die durch Einbringen der gesamten Anordnung in einen Ofen eingelötet werden. Problematisch an einer derartigen Vorgehensweise ist jedoch, daß zum Befestigen der Hybrid-Schaltung und der weiteren oberflächenmontierbaren Bauelemente auf der Leiterplatte insgesamt zwei Lötvorgänge durchgeführt werden müssen - der Lötvorgang im Ofen und im Schwallbad - .

Der Erfindung liegt die Aufgabe zugrunde, ein Verfahren anzugeben, um eine Hybrid-Schaltung sowie weitere oberflächenmontierbare Bauelemente kostengünstiger in nur einem Lötvorgang auf einer Leiterplatte zu befestigen. Zudem soll es eine preisgünstigere Herstellung von Hybrid-Schaltungen ermöglichen.

Die Erfindung wird, ausgehend von dem im Oberbegriff des Patentanspruchs 1 definierten Verfahren, durch die kennzeichnenden Merkmale des Patentanspruchs 1 gelöst.

Vorteilhaft an der Erfindung ist das Anbringen von Bohrungen auf dem Trägersubstrat der Hybrid-Schaltung. Die Bohrungen sind dabei durchkontaktiert, das heißt metallisch ausgekleidet. Weiterhin werden auf der Leiterplatte Lötflächen angebracht und mit einer Lötpaste versehen. Das Trägersubstrat mit den durchkontaktierten Bohrungen wird im folgenden auf die Lötflächen der Leiterplatte aufgesetzt. Während des Lötvorgangs in einem Ofen wird die Lötpaste flüssig und steigt beim Lötprozeß in die durchkontaktierten Bohrungen. Dabei ist vorgesehen, daß die durchkontaktierten Bohrungen in möglichst geringem Abstand zueinander angebracht werden. Damit wird erreicht, daß auftretende Abscherkräfte durch den geringen Abstand der Bohrungen zueinander nur vergleichsweise gering wirken können.

Das Anbringen von Bohrungen auf dem Trägersubstrat ist preisgünstiger als das Aufbringen der Kontaktstifte (Kämme).

Gemäß Anspruch 2 ist vorgesehen, daß die durchkontaktierten Bohrungen am Ende der Anschlüsse einer integrierten Schaltung angebracht werden. Damit ist der Vorteil verbunden, daß die elektrische Kontaktierung unmittelbar an der integrierten Schaltung erfolgt und somit eine kurze elektrische Verbindung hergestellt wird.

Gemäß Anspruch 3 ist vorgesehen, daß das eines der Bauelemente ein gedrucktes Widerstandsnetzwerk oder ein Kondensatornetzwerk ist. Damit ist der Vorteil verbunden, daß z.B. das gedruckte Widerstandsnetzwerk aus Platzgründen unterhalb der integrierten Schaltung angebracht werden kann.

Gemäß Anspruch 4 ist vorgesehen, daß ein aus wenigstens einem Kondensator bestehendes Kondensatorennetzwerk auf der Leiterplatte angebracht wird. Damit ist der Vorteil verbunden, daß das Trägersubstrat der Hybrid-Schaltung mechanisch entlastet wird.

Gemäß Anspruch 5 ist vorgesehen, daß die Bohrungen als halbkreisförmige Bohrungen im Bereich der Seitenkanten des Trägersubstrats angebracht werden. Damit ist der Vorteil verbunden, daß während des Lötvorgangs im Ofen die Lötpaste leicht in die halboffenen durchkontaktierten Bohrungen hochsteigen und die Dimensionen der Hybrid-Schaltung gering gehalten werden kann.

Gemäß Anspruch 6 ist vorgesehen, daß die durchkontaktierten Bohrungen in einer kreisförmigen Geometrie zueinander auf dem Trägersubstrat angeordnet werden. Damit ist der Vorteil verbunden, daß sehr geringe Abstände der Bohrungen untereinander wählbar sind, wodurch die Auswirkungen von auftretenden Abscherkräften gering gehalten werden.

Gemäß Anspruch 7 ist vorgesehen, daß die durchkontaktierten Bohrungen in einer rechteckförmigen Geometrie zueinander auf dem Trägersubstrat angeordnet werden. Damit ist der Vorteil verbunden, daß die durchkontaktierten Bohrungen in sehr geringem Abstand zueinander angebracht werden können, wodurch die Auswirkungen von auftretenden Abscherkräften gering gehalten werden.

Die Erfindung wird im folgenden anhand eines Ausführungsbeispiels näher erläutert.

Es zeigen:
- Figur 1: eine Draufsicht der erfindungsgemäßen Anordnung,
- Figur 2: eine Seitenansicht der erfindungsgemäßen Anordnung,
- Figur 3: das erfindungsgemäße Verfahren.

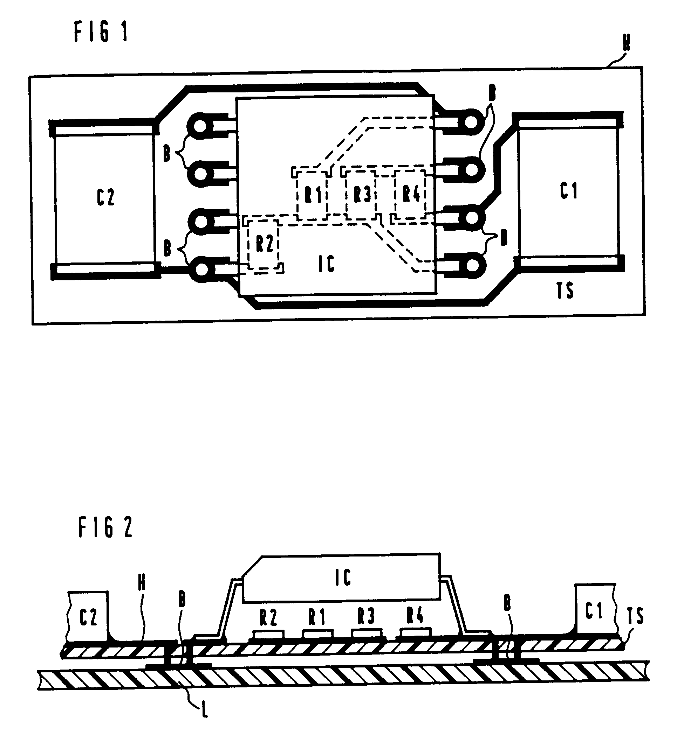

Figur 1 zeigt eine Draufsicht einer Hybrid-Schaltung H. Sie besteht aus einer Vielzahl elektrischer Bauelemente, die auf einem Trägersubstrat TS angeordnet sind. Im Ausführungsbeispiel sind dies beispielsweise eine integrierte Schaltung IC, zwei Kondensatoren C1, C2 sowie ein aus den Widerständen R1 bis R4 bestehendes Widerstandsnetzwerk. Dabei ist das Widerstandsnetzwerk als eine gedruckte Schaltung realisiert und unter der integrierten Schaltung IC angeordnet. Erfindungsgemäß werden im weiteren unmittelbar an den Anschlüssen der integrierten Schaltung IC durchkontaktierte Bohrungen B im Trägersubstrat TS angebracht. Generell ist darauf zu achten, daß die durchkontaktierten Bohrungen B in möglichst geringem geometrischen Abstand zueinander angebracht werden. Dadurch kann die Wirkung von im Erkaltungsprozeß auftretenden Abscherkräften minimiert werden. Im Ausführungsbeispiel ist diese Bedingung durch das Anbringen der kontaktierten Bohrungen B am Ende der Anschlüsse der integrierten Schaltung IC gegeben. Generell sind ebenso andere geometrische Anordnungen denkbar, wie beispielsweise das Anbringen der durchkontaktierten Bohrungen B unterhalb der integrierten Schaltung IC in einer kreisförmigen bzw. rechteckförmigen Geometrie. Eine weitere Möglichkeit besteht darin, daß halbkreisförmige Bohrungen, d.h. halboffene Bohrungen bzw. Ausnehmungen, vorgesehen sind.

Figur 2 zeigt eine Seitenansicht der Hybrid-Schaltung H zusammen mit der Leiterplatte L. Dabei ist die Hybrid-Schaltung mit ihrem Trägersubstrat TS durch eine Lötpaste auf der Leiterplatte L fixiert. Im Lötprozeß steigt die Lötpaste im flüssigen Zustand an den duchkontaktierten Bohrungen B hoch und stellt im erkalteten Zustand eine zuverlässige Verbindung zwischen den elektrischen Anschlüssen der Hybrid-Schaltung H und der Leiterplatte L dar.

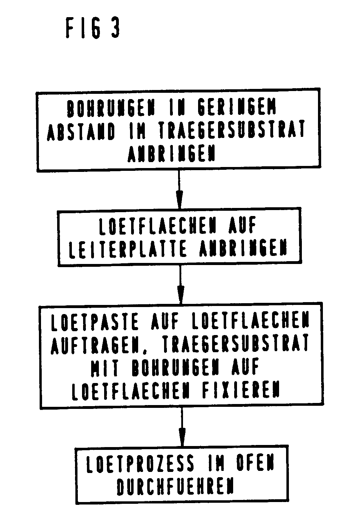

In Figur 3 ist das erfindungsgemäße Verfahren aufgezeigt. In einem ersten Schritt werden die durchkontaktierten Bohrungen B im Trägersubstrat TS angebracht. Im Ausführungsbeispiel werden die durchkontaktierten Bohrungen B am Ende der Anschlüsse der integrierten Schaltung IC angeordnet. Eine derartige Vorgehensweise stellt sicher, daß die durchkontaktierten Bohrungen B auf jeden Fall im geringen Abstand zueinander angeordnet sind. Das ist ein wesentliches Merkmal der Erfindung, da in diesem Fall die mechanischen Spannungen, die beim Erkalten des Trägersubstrats TS und der Leiterplatte L auftreten, durch die erkaltete Lötpaste abgefangen werden. In einer weiteren Ausführungsform der Erfindung sind auch andere geometrische Anordnungen der Bohrungen B möglich. So können beispielsweise die Bohrungen B kreisförmig oder in rechteckiger Form unterhalb der integrierten Schaltung IC angebracht werden.

Außerdem werden auf der Leiterplatte L Lötflächen zur späteren Kontaktierung mit dem Trägersubstrat TS angebracht. Auf die Lötflächen wird eine Lötpaste gestrichen. Die geometrische Anordnung der Lötflächen ist dabei derart zu wählen, daß das Trägersubstrat TS mit den durchkontaktierten Bohrungen B auf die Lötflächen der Leiterplatte L aufgesetzt werden kann. Die gesamte Anordnung - also die Leiterplatte L mit den Lötflächen sowie das Trägersubstrat TS mit den durchkontaktierten Bohrungen B, die nun auf den Lötflächen der Leiterplatte L fixiert sind - wird in einen Ofen gebracht. Während des Lötprozesses verflüssigt sich die Lötpaste und steigt in die durchkontaktierten Bohrungen B hinauf. Damit ist eine sichere elektrische Verbindung zwischen der Leiterplatte L und der Hybrid-Schaltung H sichergestellt.

Vorstehend wurde lediglich ein Trägersubstrat angesprochen. Abschließend sei noch vermerkt, daß als Trägersubstrat eine Vielzahl von Materialien wie beispielsweise Hartpapier, Glasfasergewebe, Kunststoff, Keramik etc. verwendet werden kann.

## Patentansprüche

1. Verfahren zum Befestigen einer Hybrid-Schaltung auf einer Leiterplatte,
die über eine, eine elektrische Kontaktierung bildende Lötverbindung mit dem Trägersubstrat (TS) der Hybrid-Schaltung (H) verbunden wird, wobei auf der Oberfläche des Trägersubstrats (TS) elektrische Bauelemente angeordnet sind und das Trägersubstrat (TS) mit durchkontaktierten Bohrungen (B) versehen ist,
**dadurch gekennzeichnet**,
daß die durchkontaktierten Bohrungen (B) in einem derart geringen Abstand zueinander angeordnet werden, daß beim Erkaltungsprozeß nach dem Löten auftretende Absdierkräfte zwischen dem Trägersubstrat (TS) und der Leiterplatte (L), die aus unterschiedlichen Materialien bestehen, abgefangen werden,
daß auf der Leiterplatte (L) Lötflächen zur elektrischen Kontaktierung der Hybrid-Schaltung vorgesehen werden,
daß eine Lötpaste auf die Lötflächen der Leiterplatte (L) aufgebracht wird und das Trägersubstrat (TS) der Hybrid-Schaltung mit den durchkontaktierten Bohrungen (B) auf die Lötflächen der Leiterplatte (L) aufgesetzt wird und
daß die gesamte Anordnung in einem Ofen gelötet wird.

2. Verfahren nach Anspruch 1,
**dadurch gekennzeichnet**,
daß die durchkontaktierten Bohrungen (B) beim Vorhandensein einer integrierten Schaltung (IC) auf dem Trägersubstrat (TS) am Ende der Anschlüsse der integrierten Schaltung (IC) angebracht werden.

3. Verfahren nach Anspruch 1 oder 2,
**dadurch gekennzeichnet**,
daß das eines der Bauelemente ein gedrucktes Widerstandsnetzwerk oder ein Kondensatornetzwerk ist.

4. Verfahren nach einem der vorhergehenden Ansprüche,
**dadurch gekennzeichnet**,
daß ein aus wenigstens einem Kondensator bestehendes Kondensatornetzwerk auf der Leiterplatte (L) angebracht wird.

5. Verfahren nach einem der vorhergehenden Ansprüche,
**dadurch gekennzeichnet**,
daß die Bohrungen (B) als halbkreisförmige Bohrungen im Bereich der Seitenkanten des Trägersubstrats (TS) angebracht werden.

6. Verfahren nach einem der vorhergehenden Ansprüche,
**dadurch gekennzeichnet**,
daß die durchkontaktierten Bohrungen (B) in einer kreisförmigen Geometrie zueinander auf dem Trägersubstrat (TS) angeordnet werden.

7. Verfahren nach einem der Ansprüche 1 bis 5,
**dadurch gekennzeichnet**,
daß die durchkontaktierten Bohrungen (B) in einer rechteckförmigen Geometrie zueinander auf dem Trägersubstrat (TS) angeordnet werden.

## Claims

1. Method of securing a hybrid circuit on a printed circuit board, which is connected to the carrier substrate (TS) of the hybrid circuit (H) by means of a soldered joint which forms an electrical contact, electrical components being arranged on the surface of the carrier substrate (TS) and the carrier substrate (TS) being provided with plated-through holes (B), characterized
in that the plated-through holes (B) are arranged at such a short distance from one another that shear forces, occurring after soldering during the cooling-down process, between the carrier substrate (TS) and the printed circuit board (L), which are composed of different materials, are absorbed,
in that soldering areas for making electrical contact with the hybrid circuit are provided on the printed circuit board (L),
in that a solder paste is applied to the soldering areas of the printed circuit board (L), and the carrier substrate (TS) of the hybrid circuit having the plated-through holes (B) is placed onto the soldering areas of the printed circuit board (L), and
in that the entire arrangement is soldered in a furnace.

2. Method according to Claim 1,
characterized
in that when there is an integrated circuit (IC) on the carrier substrate (TS), the plated-through holes (B) are provided at the end of the terminals of the integrated circuit (IC).

3. Method according to Claim 1 or 2,
characterized
in that one of the components is a printed resistor network or a capacitor network.

4. Method according to one of the preceding claims,
characterized
in that a capacitor network comprising at least one capacitor is provided on the printed circuit board (L).

5. Method according to one of the preceding claims,
characterized
in that the holes (B) are provided as semicircular holes in the region of the side edges of the carrier substrate (TS).

6. Method according to one of the preceding claims,
characterized
in that the plated-through holes (B) are arranged in a circular geometry relative to one another on the carrier substrate (TS).

7. Method according to one of Claims 1 to 5,
characterized
in that the plated-through holes (B) are arranged in a rectangular geometry relative to one another on the carrier substrate (TS).

## Revendications

1. Procédé de fixation d'un circuit hybride à une plaquette à circuits imprimés, qui est reliée au substrat (TS) de support du circuit (H) hybride par l'intermédiaire d'un joint brasé formant contact électrique, des composants électriques étant montés à la surface du substrat (TS) de support et le substrat (TS) de support étant muni de trous (B) métallisés, caractérisé en ce que l'on ménage les trous (B) métallisés à une distance si petite les uns des autres que des forces de cisaillement apparaissant, après le brasage, lors du processus de refroidissement, entre le substrat (TS) de support et la plaquette (L) à circuits imprimés, qui sont constitués de matériaux différents, sont absorbées, en ce que l'on prévoit sur la plaquette (L) à circuits imprimés des surfaces à braser destinées à la mise en contact électrique du circuit hybride, en ce que l'on dépose une pâte à braser sur les surfaces à braser de la plaquette (L) à circuits imprimés, et en ce que l'on pose le substrat (TS) de support du circuit (H) hybride ayant les trous (B) métallisés sur les surfaces à braser de la plaquette (L) à circuits imprimés, et en ce que l'on brase le tout dans un four.

2. Procédé suivant la revendication 1, caractérisé en ce que, lorsqu'un circuit (IC) intégré est présent sur le substrat (TS) de support, on ménage les trous (B) métallisés à l'extrémité des bornes du circuit (IC) intégré.

3. Procédé suivant la revendication 1 ou 2, caractérisé en ce qu'un des composants est un réseau de résistances, ou un réseau de condensateurs, imprimé.

4. Procédé suivant une des revendications précédentes, caractérisé en ce qu'il est monté sur la plaquette (L) à circuits imprimé un réseau de condensateurs constitué d'au moins un condensateur.

5. Procédé suivant une des revendications précédentes, caractérisé en ce que les trous (B) sont ménagés sous forme de trous semi-circulaires dans la région des bords latéraux du substrat (TS) de support.

6. Procédé suivant une des revendications précédentes, caractérisé en ce que les trous (B) métallisés sont disposés sur le substrat (TS) de support en une géométrie circulaire les uns par rapport aux autres.

7. Procédé suivant une des revendications 1 à 5, caractérisé en ce que les trous (B) métallisés sont disposés sur le substrat (TS) de support en une géométrie rectangulaire les uns par rapport aux autres.
